# EUROPÄISCHE PATENTSCHRIFT

(11) **EP 2 179 318 B1**
(45) Veröffentlichungstag und Bekanntmachung des Hinweises auf die Patenterteilung: **07.03.2012**
(21) Anmeldenummer: 08774625.1
(22) Anmeldetag: 02.07.2008
(51) Int. Cl.: G02B 26/10, B81B 3/00

(54) **MIKROMECHANISCHES BAUELEMENT UND VERFAHREN ZUR SCHWINGUNGSANREGUNG EINES SCHWINGUNGSELEMENTS EINES MIKROMECHANISCHEN BAUELEMENTS**
MICROMECHANICAL COMPONENT AND METHOD FOR OSCILLATION EXCITATION OF AN OSCILLATION ELEMENT OF A MICROMECHANICAL COMPONENT
COMPOSANT MICROMÉCANIQUE ET PROCÉDÉ POUR AMORCER LES OSCILLATIONS D'UN ÉLÉMENT VIBRANT D'UN COMPOSANT MICROMÉCANIQUE

(30) Priorität: 09.08.2007 DE 102007037555
(43) Veröffentlichungstag der Anmeldung: 28.04.2010
(73) Patentinhaber: Robert Bosch GmbH, 70442 Stuttgart (DE)
(72) Erfinder: SATTLER, Robert, 71229 Leonberg (DE)
(86) Internationale Anmeldenummer: PCT/EP2008/058486
(87) Internationale Veröffentlichungsnummer: WO 2009/019086

(56) Entgegenhaltungen:
- WO-A-98/44571
- DE-A1- 10 119 073
- US-A1- 2005 128 552
- US-A1- 2005 253 055
- SCHENK H ET AL: "An electrostatically excited 2D-micro-scanning-mirror with an in-plane configuration of the driving electrodes" 20000123; 20000123 - 20000127, 23. Januar 2000 (2000-01-23), Seiten 473-478, XP010377173

## Beschreibung

### Stand der Technik

Die Erfindung geht aus von einem mikromechanischen Bauelement nach dem Oberbegriff des Anspruchs 1 aus.

Solche mikromechanischen Bauelemente sind allgemein bekannt. Beispielsweise ist aus der Druckschrift DE 603 08 752 T2 eine Mikrospiegeleinheit bekannt, wobei der Mikrospiegel um eine Achse beweglich und in einem um eine weitere Achse beweglichen inneren Rahmen befestigt ist. Der Spiegel ist an einem Rahmen befestigt und wird durch eine Kopplung über Aufhängungselemente von dem Rahmen zu Schwingungen angeregt. Nachteilig an dieser Mikrospiegeleinheit ist, dass eine effiziente Anregung des Rahmens in eine erste Schwingung und eine gleichzeitige effiziente Anregung des Mikrospiegels in zweite Schwingung mit derselben Anregungsfrequenz nicht möglich ist. Folglich sind nur geringe Auslenkungswinkel des Mikrospiegels realisierbar und die Anregung des Mikrospiegels zu größeren Auslenkungswinkeln würde einen erheblichen Energieaufwand erfordern. Ein Gegenstand nach dem Oberbegriff des Anspruchs 1 ist auch aus der Schrift US 2005/253055 A1 bekannt.

### Offenbarung der Erfindung

Das erfindungsgemäße mikromechanische Bauelement und das Verfahren zur Schwingungsanregung eines Schwingungselements eines mikromechanischen Bauelements gemäß den nebengeordneten Ansprüchen haben den Vorteil, dass gegenüber dem Stand der Technik deutlich größere Auslenkungswinkel des Schwingungselements und ein verkleinertes Design des mikromechanischen Bauelements bei geringeren Antriebsströmen ermöglicht werden. Efindungsgemäß wird durch eine Dimensionierungsanpassung des äußeren Aufhängeelements die Eigenfrequenz des Rahmens derart verschoben, dass die beiden Resonanzschwingungen maximal gekoppelt sind und folglich eine doppelt-resonante Anregung der ersten Schwingung und der zweiten Schwingung mit einer Anregungsfrequenz in einer im Vergleich zum Stand der Technik erheblich effizienteren Weise ermöglicht wird. Durch die resonante und damit effiziente Anregung der ersten Schwingung, ist auch die Anregung der zweiten Schwingung über das innere Aufhängungselement mit der Anregungsfrequenz gegenüber dem Stand der Technik erheblich effizienter und es werden größere Auslenkungswinkel des Schwingungselements mit geringeren Antriebskräften erzielt. Die Kopplung zwischen der ersten und der zweiten Schwingung wird durch die Steifigkeit des äußeren Aufhängeelements festgelegt, wobei durch eine geeignete Dimensionierung des äußeren Aufhängeelements die Steifigkeit derart gewählt wird, dass die Resonanzfrequenz der ersten Schwingung innerhalb der Halbwertsbreite der Resonanzkurve der zweiten Schwingung liegt. Eine Schwingungsanregung weist die maximale Effizienz im Bereich der Resonanzfrequenz auf, so dass die doppelt-resonante Schwingungsanregung der ersten und zweiten Schwingung im Vergleich zum Stand der Technik eine erheblich größere Effizienz aufweist. Die Halbwertsbreite im Sinne der vorliegenden Erfindung definiert ein schmales Frequenzband um die Resonanzfrequenz, wobei die Resonanzfrequenz diejenige Frequenz ist, bei der die Frequenzkurve ein Maximum aufweist und wobei in dem Frequenzband die Anregung einer Schwingung eine maximale Effizienz aufweist.

Vorteilhafte Ausgestaltungen und Weiterbildungen der Erfindung sind in den Unteransprüchen, sowie der Beschreibung unter Bezugnahme auf die Zeichnung entnehmbar.

Erfindungsgemäß ist die Kopplung zwischen der ersten und der zweiten Schwingung maximal, so dass in besonders vorteilhafter Weise eine vergleichsweise effiziente Schwingungsanregung sowohl der ersten und der zweiten Schwingung erzielt wird. Insbesondere wird die Kopplung maximal, wenn die Steifigkeit des äußeren Aufhängelements maximal um 20% von einem Produkt aus der Masse des äußeren Rahmens und dem Quadrat einer zweiten Resonanzfrequenz bezüglich einer ungekoppelten Schwingung des Schwingungselements um die zweite Achse, bevorzugt maximal um 10% und besonders bevorzugt maximal um 5% abweicht.

Gemäß einer bevorzugten Weiterbildung des mikromechanischen Bauelements weist der Rahmen wenigstens eine Leiterbahn auf, wobei in der Gleichgewichtslage des Rahmens die Leiterbahn eine Stromschleife in einer zur Haupterstreckungsebene parallelen Ebene entlang des Rahmens und um das Schwingungselement herum bildet. Die Stromschleife bewirkt im Falle einer anliegenden elektrischen Potentialdifferenz und deren Durchsetzung durch ein äußeres Magnetfeld eine Lorentzkraft, welche auf den Rahmen wirkt und von der Richtung und dem Betrag der Stromstärke in der Leiterbahn und dem Magnetfeld abhängt. Im Falle eines anliegenden homogenen Magnetfeldes ist die Kraftwirkung auf zwei in der Haupterstreckungsrichtung gegenüberliegende Rahmenteile dem Betrage nach gleich, aber diametral entgegengesetzt, da der Stromfluss in den Rahmenteilen ebenfalls betragsmäßig gleich, aber in der Richtung diametral entgegengesetzt ist. Dadurch wirkt ein Drehmoment auf den Rahmen um die erste und/oder die zweite Achse und wird über das innere Aufhängungselement auf das Schwingungselement übertragen. Erfindungsgemäß ist eine doppelt-resonante Schwingungsanregung um die zweite Achse vorgesehen, so dass geringere Antriebskräfte im Vergleich zum Stand der Technik größere Auslenkungswinkel des Schwingungselements erzielen.

Gemäß einer weiteren bevorzugten Weiterbildung weist das Schwingungselement einen Mikrospiegel auf, wobei insbesondere das Schwingungselement selbst ein Mikrospiegel ist. Dadurch ist das mikromechanische Bauelement vorteilhaft als bewegliche Mikrospiegeleinheit zur Reflexion und Projektion eines Lichtstrahls, insbesondere in der Bildschirmtechnologie, wobei die Qualität der Abbildung durch vergleichsweise große Spiegelauslenkungswinkel erheblich verbessert wird, einsetzbar.

Ein weiterer Gegenstand der vorliegenden Erfindung ist ein Verfahren zur Schwingungsanregung eines Schwingungselements eines mikromechanischen Bauelements, wobei die erste Schwingung und die zweite Schwingung mit einer Anregungsfrequenz angeregt werden. Vorteilhaft ermöglicht diese doppelt-resonante Anregung des Rahmens eine im Vergleich zum Stand der Technik erheblich effizientere Anregung des Schwingungselements und somit insbesondere größere Winkelauslenkungen des Schwingungselements mit geringeren Strömen und einem kleineren Design des mikromechanischen Bauelements.

Gemäß einer bevorzugten Weiterbildung erfolgt die Anregung der ersten und der zweiten Schwingung mittels einer periodischen Stromstärkenvariation mit der Anregungsfrequenz in der Leiterbahn und unter Anlage eines Magnetfeldes. Die Stromstärkenvariation bewirkt die Lorenzkraft, welche das Drehmoment auf den Rahmen ausübt und die zweite Schwingung bewirkt. Aufgrund der doppelt-resonanten Anregung wird die zweite Schwingung über die Kopplung des inneren Aufhängeelements durch die erste Schwingung in besonders effizienter Weise angeregt und eine vergleichsweise hohe Effizienz bei der Umwandlung von Anregungsenergie in Schwingungsenergie erzielt.

Gemäß einer weiteren bevorzugten Weiterbildung erfolgt eine Anregung einer dritten Schwingung des Rahmens um die erste Achse mit einer weiteren Anregungsfrequenz. Vorteilhaft wird somit eine Auslenkung bzw. eine Verkippung des Rahmens bzw. des Schwingungselements um die erste Achse und gleichzeitig um die zweite Achse ermöglicht.

Gemäß einer weiteren bevorzugten Weiterbildung erfolgt die Anregung der dritten Schwingung mittels einer periodischen Stromstärkenvariation mit der weiteren Anregungsfrequenz in der Leiterbahn und unter Anlage des Magnetfelds, wobei eine auf den Rahmen wirkende Lorenzkraft derart induziert wird, dass der Rahmen ein Drehmoment bezüglich der ersten Achse erfährt. Durch eine periodische Variation der Stromstärke in der Leiterbahn mit der weiteren Anregungsfrequenz wird der Rahmen und durch die Kopplung über das innere Aufhängeelement auch das Schwingungselement folglich zur dritten Schwingung angeregt.

Gemäß einer weiteren bevorzugten Weiterbildung erfolgt die Anregung der ersten, der zweiten und der dritten Schwingung mittels einer Überlagerung zweier periodischer Stromstärkenvariationen mit Anregungsfrequenz und der weiteren Anregungsfrequenz in der Leiterbahn und unter Anlage des Magnetfeldes. Vorteilhaft wird somit in einfacher Weise eine Anregung der ersten, zweiten und dritten Schwingung erzielt.

Ausführungsbeispiele der Erfindung sind in den Zeichnungen dargestellt und in der nachfolgenden Beschreibung näher erläutert.

### Kurze Beschreibung der Zeichnung

Es zeigen:
- Figur 1: eine schematische Darstellung eines erfindungsgemäßen mikromechanischen Bauelements gemäß einer ersten Ausführungsform, wobei eine beispielhafte Winkelauslenkung einer dritten Resonanzschwingung eines Rahmens um eine erste Achse dargestellt ist,
- Figur 2: eine schematische Darstellung eines erfindungsgemäßen mikromechanischen Bauelements gemäß der ersten Ausführungsform, wobei eine beispielhafte Winkelauslenkung einer ersten Resonanzschwingung des Rahmens um eine zweite Achse dargestellt ist,
- Figur 3: eine schematische Darstellung eines erfindungsgemäßen mikromechanischen Bauelements gemäß der ersten Ausführungsform, wobei eine beispielhafte Winkelauslenkung einer zweiten Resonanzschwingung eines Schwingungselements relativ zum Rahmen um die zweite Achse dargestellt ist,
- Figur 4: eine schematische Darstellung eines erfindungsgemäßen mikromechanischen Bauelements gemäß einer zweiten Ausführungsform und
- Figur 5: beispielhaft einen Verlauf einer Winkelauslenkung des Rahmens und des Schwingungselement des erfindungsgemäßen mikromechanischen Bauelements gemäß der ersten Ausführungsform in Abhängigkeit von der relativen Steifigkeit eines äußeren Aufhängeelements des Rahmens.

### Ausführungsform(en) der Erfindung

In den verschiedenen Figuren sind gleiche Teile stets mit den gleichen Bezugszeichen versehen und werden daher in der Regel auch jeweils nur einmal benannt.

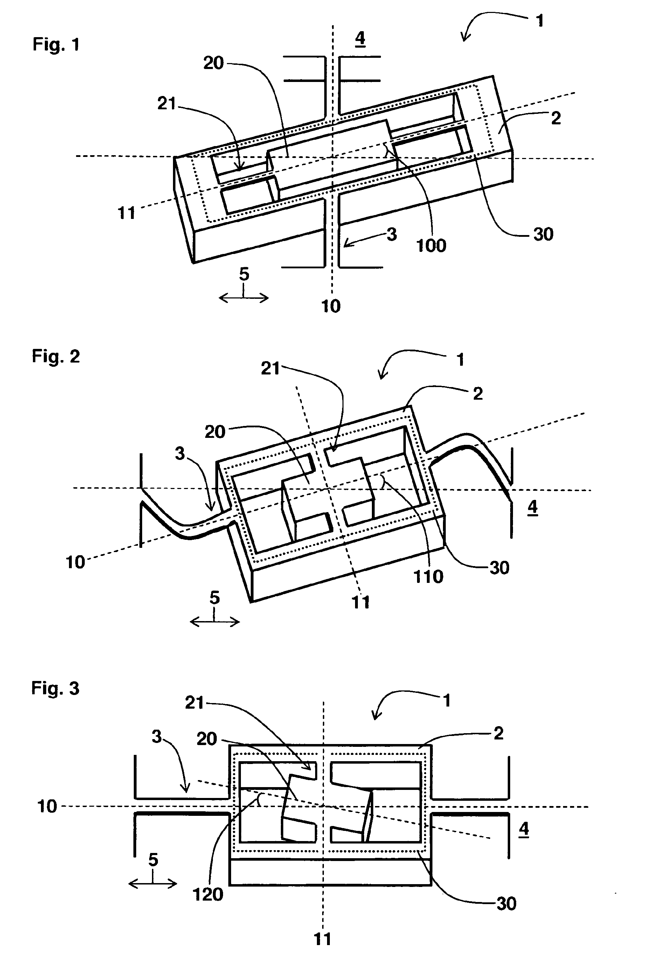

In Figur 1 ist eine schematische perspektivische Darstellung eines erfindungsgemäßen mikromechanischen Bauelements 1 gemäß einer ersten Ausführungsform dargestellt, wobei das mikromechanische Bauelement 1 einen Rahmen 2 aufweist, welcher durch ein äußeres Aufhängeelement 3 mit einem Trägersubstrat 4 verbunden ist, wobei der Rahmen 2 um eine erste Achse 10 in einer Haupterstreckungsebene 5 des Trägersubstrats 4 verkippbar und um eine zur ersten Achse 10 senkrecht stehende zweite Achse 11 in der Haupterstreckungsebene 5 schwingfähig ist, und wobei das mikromechanische Bauelement 1 ein Schwingungselement 20 aufweist, welches durch ein inneres Aufhängeelement 21 mit dem Rahmen 2 verbunden und um die zweite Achse 11 verkippbar ist. Der Rahmen 2 weist in der Darstellung eine beispielhafte Winkelauslenkung 100 des Rahmens 2 um die erste Achse 10 einer dritten Resonanzschwingung des Rahmens 2 auf.

In Figur 2 ist eine schematische perspektivische Darstellung des erfindungsgemäßen mikromechanischen Bauelements 1 gemäß der ersten Ausführungsform dargestellt, wobei die Darstellung gegenüber der Darstellung in der Figur 1 um einen 90° Winkel um die Flächennormale der Haupterstreckungsebene 5 gedreht wurde und eine beispielhafte Winkelauslenkung 110 des Rahmens 2 um die zweite Achse 11 einer ersten Resonanzschwingung, wobei der Rahmen 2 um die zweite Achse 11 schwingt, dargestellt ist.

In Figur 3 ist eine schematische perspektivische Darstellung des erfindungsgemäßen mikromechanischen Bauelements 1 gemäß der ersten Ausführungsform dargestellt, wobei die Darstellung gegenüber der Darstellung in der Figur 2 eine beispielhafte Winkelauslenkung 120 des Schwingungselements 20 um die zweite Achse 11 einer zweiten Resonanzschwingung, wobei das Schwingungselement 20 um die zweite Achse 11 schwingt, dargestellt ist.

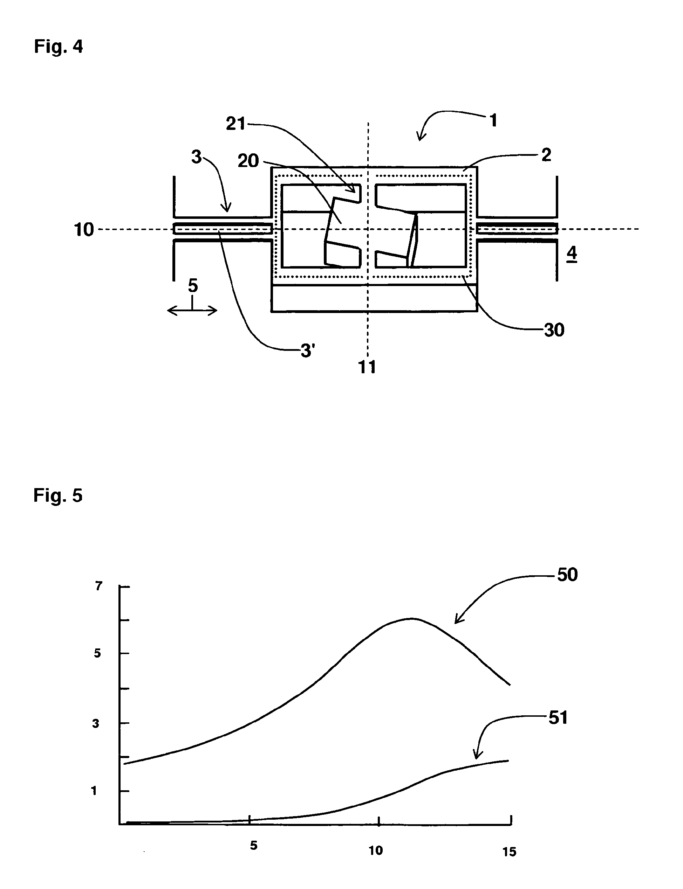

In Figur 4 ist eine schematische perspektivische Darstellung eines erfindungsgemäßen mikromechanischen Bauelements gemäß einer zweiten Ausführungsform dargestellt, wobei sich die zweite Ausführungsform lediglich in einem veränderten äußeren Aufhängeelement 3 von der ersten Ausführungsform, welche in Figur 1 bis 3 illustriert ist, unterscheidet. Dargestellt ist eine beispielhafte Struktur eines äußeren Aufhängeelements 3, welches die geforderte erfindungsgemäße Steifigkeit aufweist, um die Resonanzkurve der zweiten Resonanzschwingung derart zu verschieben, dass die beiden Schwingungen stark gekoppelt sind.

In Figur 5 ist beispielhaft ein Verlauf einer Winkelauslenkung eines Rahmens und eines mit dem Rahmen verbundenen Schwingungselements eines erfindungsgemäßen mikromechanischen Bauelements gemäß der ersten Ausführungsform in Abhängigkeit von der relativen Steifigkeit des äußeren Aufhängeelements in einem Graph dargestellt. An einer Abszisse ist die relative Steifigkeit des äußeren Aufhängeelements und an einer Ordinate die Winkelauslenkung in Grad aufgetragen. Eine erste Funktionskurve 50 beschreibt die Winkelauslenkung des Schwingungselements um die zweite Achse und eine zweite Kurve 51 die Winkelauslenkung des Rahmens um die zweite Achse. Erfindungsgemäß maximiert eine entsprechende Dimensionierung des äußeren Aufhängeelements die Winkelauslenkung des Schwingungselements bei gleichen Anregungsbedingungen. Das Maximum der Winkelauslenkungskurve 50 des Schwingungselements liegt in dem dargestellten Graphen beispielhaft bei einer relativen Verstärkung von elf. Der Graph zeigt, dass eine gezielte Dimensionierung, insbesondere Versteifung, des äußeren Aufhängungselements eine Maximierung der Winkelauslenkung des Schwingungselements bei gleichen Anregungsbedingungen bewirkt.

## Patentansprüche

1. Mikromechanisches Bauelement (1), wobei das mikromechanische Bauelement (1) einen Rahmen (2) aufweist, welcher durch ein äußeres Aufhängeelement (3) mit einem Trägersubstrat (4) verbunden ist, wobei der Rahmen (2) um eine erste Achse (10) in einer Haupterstreckungsebene (5) des Trägersubstrats (4) verkippbar und um eine zur ersten Achse (10) senkrecht stehende zweite Achse (11) in der Haupterstreckungsebene (5) schwingfähig ist, und wobei das mikromechanische Bauelement (1) ein Schwingungselement (20) aufweist, welches durch ein inneres Aufhängeelement (21) mit dem Rahmen (2) verbunden und um die zweite Achse (11) verkippbar ist, **dadurch gekennzeichnet, dass** das äußere Aufhängeelement (3) derart dimensioniert vorgesehen ist, eine Resonanzfrequenz einer ersten Schwingung des Rahmens (2) um die zweite Achse (11) innerhalb einer Halbwertsbreite einer Resonanzkurve einer zweiten Schwingung des Schwingungselements (20) um die zweite Achse (11) liegt, wobei die Steifigkeit des äußeren Aufhängelements (3) maximal um 20% von einem Produkt aus der Masse des äußeren Rahmens (2) und dem Quadrat einer zweiten Resonanzfrequenz bezüglich einer ungekoppelten Schwingung des Schwingungselements (20) um die zweite Achse (11) abweicht, bevorzugt maximal um 10% und besonders bevorzugt maximal um 5%.

2. Mikromechanisches Bauelement (1) nach Anspruch 1, **dadurch gekennzeichnet, dass** die erste Schwingung und die zweite Schwingung eine maximale Kopplung aufweisen.

3. Mikromechanisches Bauelement (1) gemäß einem der vorhergehenden Ansprüche, **dadurch gekennzeichnet, dass** der Rahmen (2) wenigstens eine Leiterbahn (30) aufweist, wobei in der Gleichgewichtslage des Rahmens (2) die Leiterbahn (30) eine Stromschleife in einer zur Haupterstreckungsebene (5) parallelen Ebene entlang des Rahmens (2) und um das Schwingungselement (20) herum bildet.

4. Mikromechanisches Bauelement (1) gemäß einem der vorhergehenden Ansprüche, **dadurch gekennzeichnet, dass** das Schwingungselement (20) einen Mikrospiegel aufweist.

## Claims

1. Micromechanical component (1), wherein the micromechanical component (1) has a frame (2), which is connected to a carrier substrate (4) by an outer suspension element (3), wherein the frame (2) is tiltable about a first axis (10) in a main extension plane (5) of the carrier substrate (4) and is capable of oscillating about a second axis (11) which is perpendicular to the first axis (10), in the main extension plane (5), and wherein the micromechanical component (1) has an oscillation element (20), which is connected to the frame (2) by an inner suspension element (21) and is tiltable about the second axis (11), **characterized in that** the outer suspension element (3) is provided in a manner dimensioned in such a way that a resonant frequency of a first oscillation of the frame (2) about the second axis (11) lies within a full width at half maximum of a resonant curve of a second oscillation of the oscillation element (20) about the second axis (11), wherein the stiffness of the outer suspension element (3) deviates at most by 20% from a product of the mass of the outer frame (2) and the square of a second resonant frequency with respect to an uncoupled oscillation of the oscillation element (20) about the second axis (11), preferably at most by 10%, and particularly preferably at most by 5%.

2. Micromechanical component (1) according to Claim 1, **characterized in that** the first oscillation and the second oscillation have a maximum coupling.

3. Micromechanical component (1) according to either of the preceding claims, **characterized in that** the frame (2) has at least one conductor track (30), wherein, in the equilibrium position of the frame (2), the conductor track (30) forms a current loop in a plane parallel to the main extension plane (5) along the frame (2) and around the oscillation element (20).

4. Micromechanical component (1) according to any of the preceding claims, **characterized in that** the oscillation element (20) has a micromirror.

## Revendications

1. Composant micromécanique (1), le composant micromécanique (1) présentant un bâti (2) relié à un substrat porteur (4) par un élément extérieur de suspension (3),
le bâti (2) pouvant basculer autour d'un premier axe (10) dans un plan d'extension principale (5) du substrat porteur (4) et pouvant osciller dans le plan d'extension principale (5) autour d'un deuxième axe (11) perpendiculaire au premier axe (10),
le composant micromécanique (1) présentant un élément oscillant (20) qui est relié au bâti (2) par un élément intérieur de suspension (21) et qui peut basculer autour du deuxième axe (11),
**caractérisé en ce que**
l'élément extérieur de suspension (3) est dimensionné de telle sorte qu'une fréquence de résonance d'une première vibration du bâti (2) autour du deuxième axe (11) soit située à l'intérieur de la largeur des demi-valeurs d'une courbe de résonance d'une deuxième vibration de l'élément oscillant (20) autour du deuxième axe (11),
**en ce qu'**en l'absence de couplage de la vibration de l'élément oscillant (20) autour du deuxième axe (11), la rigidité de l'élément extérieur de suspension (3) s'écarte d'au plus 20 %, de préférence d'au plus 10 % et de façon particulièrement préférable d'au plus 5 % du produit de la masse du bâti extérieur (2) et du carré d'une deuxième fréquence de résonance.

2. Composant micromécanique (1) selon la revendication 1, **caractérisé en ce que** la première vibration et la deuxième vibration présentent un couplage maximum.

3. Composant micromécanique (1) selon l'une des revendications précédentes, **caractérisé en ce que** le bâti (2) présente au moins une piste conductrice (30), la piste conductrice (30) formant une boucle de courant dans un plan parallèle au plan d'extension principale (5) le long du bâti (2) et autour de l'élément oscillant (20) lorsque le bâti (2) est situé en position d'équilibre.

4. Composant micromécanique (1) selon l'une des revendications précédentes, **caractérisé en ce que** l'élément oscillant (20) présente un micromiroir.
